## Europäisches Patentamt

(19) **European Patent Office**

**Office européen des brevets**

(11) Veröffentlichungsnummer: **0 013 310**
**B1**

(12) **EUROPÄISCHE PATENTSCHRIFT**

(45) Veröffentlichungstag der Patentschrift:
**13.04.83**

(21) Anmeldenummer: **79104412.6**

(22) Anmeldetag: **09.11.79**

(51) Int. Cl.³: **C 23 G 1/00**, C 25 D 5/34,
G 03 F 7/02 // H05K3/26

(54) **Verfahren zur Herstellung eines Photoresistbildes.**

(30) Priorität: **17.11.78 DE 2849894**

(43) Veröffentlichungstag der Anmeldung:
**23.07.80 Patentblatt 80/15**

(45) Bekanntmachung des Hinweises auf die Patenterteilung:
**13.04.83 Patentblatt 83/15**

(84) . Benannte Vertragsstaaten:
**AT BE CH DE FR GB IT NL SE**

(56) Entgegenhaltungen:
**DE-A-2 364 631**
**FR-A-1 577 582**
**FR-A-2 366 350**
**US-A-3 905 907**
**CHEMICAL ABSTRACTS, Band 81, Nr. 10, 9. September 1974, Zusammenfassung Nr. 53618m, Columbus, Ohio, US.**

(73) Patentinhaber· **HOECHST AKTIENGESELLSCHAFT,
Postfach 80 03 20, D-6230 Frankfurt/Main 80 (DE)**

(72) Erfinder: **Herwig, Walter, Dr., Hasenpfad 7, D-6232 Bad Soden (DE)**
Erfinder: **Klüpfel, Kurt, Dr., Dreispitzstrasse 2a, D-6200 Wiesbaden-Sonnenberg (DE)**
Erfinder: **Sikora, Helga, Bunsenstrasse 6f, D-6200 Wiesbaden 12 (DE)**
Erfinder: **Sprengel, Heide, Elsa-Brandström-Strasse 10, D-6200 Wiesbaden 12 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**0 013 310**

Verfahren zur Herstellung eines Photoresistbildes

Die Erfindung betrifft ein Verfahren zur Herstellung eines Photoresistbilds, bei dem auf einen Schichtträger aus Kupfer oder einer Kupferlegierung eine photopolymerisierbare Photoresistschicht aufgebracht, bildmäßig belichtet und an den unbelichteten Bereichen mittels einer wäßrig-alkalischen Entwicklerlösung ausgewaschen wird.

Bei der Leiterplattenfertigung nach dem Photoresistverfahren wird auf der Oberfläche, auf der galvanische Leiterzüge abgeschieden werden sollen, durch Aufbringen einer Photoresistschicht, Belichten und Entwickeln eine Resistschablone erzeugt. Die dabei bildmäßig freigelegte Metalloberfläche, die normalerweise aus Kupfer oder einer Kupferlegierung besteht, muß vor dem Galvanisieren sorgfältig gereinigt werden, um gute Haftung und Homogenität der abgeschiedenen Leiterzüge zu erreichen. Das ist nur schwierig zu erreichen, wenn es sich um sehr feine Leiterzüge handelt, die zwischen Resiststreifen von nur wenigen μm Abstand liegen. Es ist in jedem Falle erforderlich, die nach der Entwicklung freigelegte Metalloberfläche in mindestens einem Behandlungsschritt einer intensiven Reinigung zu unterziehen, wobei vor allem noch anhaftende Resistreste vollständig entfernt werden sollen.

Reinigungsmittel für Metalloberflächen, die gegebenenfalls nachträglich galvanisiert werden sollen, sind z. B. in der GB-A 1 066 407 beschrieben. Dort werden Kombinationen von nichtionogenen Netzmitteln mit Fettsäuren und Alkanolaminen verwendet.

Die DE-C 1 958 875 beschreibt eine Waschflüssigkeit zum Reinigen der Oberfläche von gedruckten Schaltungen, um nach dem Löten zurückgebliebene Harzreste zu entfernen. Die Flüssigkeit besteht aus einem Gemisch von Toluol, Butylacetat und Isopropanol.

In der US-A 3 030 238 werden wäßrige Lösungen von Polyglykolätherkondensaten, Alkylarylsulfonaten oder bestimmten Ammoniumverbindungen als Reinigungsmittel für Metalloberflächen beschrieben.

Die DE-A 2 136 285 beschreibt Reinigungsmittel für Metalloberflächen, die Metallsilikate, -chloride, nichtionische Netzmittel und Chelatbildner enthalten.

In der US-A 3 905 907 werden stark saure wäßrige Lösungen von Wasserstoffperoxid, die aliphatische Sulfonsäuren mit 1−18 C-Atomen oder deren Salze enthalten, zur chemischen Behandlung von Metalloberflächen beschrieben. Die Lösungen dienen zur Entfernung oxidischer Beläge, und die Sulfonsäuren haben die Funktion, die Zersetzung des Peroxids bei der Lagerung zu verhindern.

Alle diese Mittel sind nicht zur selektiven Reinigung bestimmt, bei der an den durch Entwicklung freigelegten Stellen alle Schichtreste entfernt werden, während die gehärteten Schichtbereiche an den abgedeckten Stellen des Metalls unangegriffen bleiben sollen. Sie sind demgemäß nur begrenzt oder überhaupt nicht für diesen Zweck geeignet. Viele derartige Mittel sind durch ihren hohen Gehalt an organischen Lösungsmitteln nachteilig und können nur unter besonderen Vorsichtsmaßnahmen angewendet werden.

Zur Reinigung von nach der Photoresisttechnik bildmäßig abgedeckten Metalloberflächen hat man deshalb bisher die Metalloberfläche, z. B. mit Ammoniumperoxidisulfat, angeätzt und danach kurze Zeit mit Schwefelsäure behandelt, wie es z. B. in der DE-A-2 448 821, Beispiel 1, beschrieben ist. Man erhält bei ausreichend langem Anätzen schließlich eine saubere Oberfläche, doch besteht die Gefahr, daß durch zu ausgedehntes Anätzen dünne Kupferschichten durchgeätzt werden.

Diese Probleme treten insbesondere bei der Verwendung von Photoresistmaterialien auf, die eine besonders gute Haftung gegenüber dem Metall aufweisen. Diese Eigenschaft, die für eine gute Resistenz der Bildschablone gegenüber galvanischen Bädern sehr erwünscht ist, wird z. B. durch Zusatz von bestimmten Haftvermittlern erreicht, wie es in der zuvorgenannten DE-A beschrieben wird.

Aufgabe der Erfindung war es daher, ein Verfahren zur Herstellung eines Photoresistbilds auf Kupfer enthaltenden Metalloberflächen vorzuschlagen, das eine vollständige Reinigung der bildmäßig freigelegten Metalloberfläche unter umweltfreundlichen Bedingungen erlaubt, ohne daß das zu reinigende Metall zu stark abgetragen wird.

Die Erfindung geht aus von einem Verfahren zur Herstellung eines Photoresistbilds, wie es eingangs angegeben worden ist.

Das erfindungsgemäße Verfahren ist dadurch gekennzeichnet, daß man die Oberfläche des Trägers während des Entwickelns oder nach dem Entwickeln mit einer Lösung behandelt, die eine wasserlösliche aliphatische Sulfonsäure mit 8 bis 30 C-Atomen oder ein wasserlösliches Salz einer solchen Sulfonsäure enthält.

Das Verfahren ist ganz allgemein wirksam, wenn man eine saubere, von organischen, insbesondere hochmolekularen Verunreinigungen freie Kupferoberfläche braucht, auf der eine weitere, fest haftende Metallschicht galvanisch oder auch stromlos abgeschieden werden soll.

Bevorzugte Anwendung findet das Verfahren bei der Herstellung von Leiterplatten, z. B. kopierten Schaltbildern, nach der Photoresisttechnik. Die Photoschablone kann hierbei sowohl mit positiv arbeitenden Photoresistmaterialien, z. B. auf der Basis von o-Naphthochinondiaziden, als auch mit negativ arbeitenden Photoresistschichten erzeugt werden. Bevorzugt werden negativ arbeitende, also

2

lichthärtbare Schichten verwendet, z. B. solche aus lichtvernetzbaren Substanzen, wie Polyvinylcinnamaten, p-Chinondiaziden, Azidoverbindungen, ggf. in Kombination mit vernetzbaren Polymeren, oder aus photopolymerisierbaren Gemischen.

Hierbei wird die lichtempfindliche Schicht durch Beschichten aus einer Lösung oder durch Laminieren einer vorgefertigten festen Schicht auf eine Metallfolie, vorzugsweise aus Kupfer, aufgebracht, die mit einer Isolierstoffplatte kaschiert ist. Die lichtempfindliche Schicht wird unter einer Vorlage, z. B. einem Schaltbild, belichtet, die Bildstellen, an denen später die Leiterzüge liegen sollen, werden durch Auswaschen entwickelt und die freigelegten Metallbereiche gegebenenfalls angeätzt. Auf diesen Metallbereichen wird dann stromlos oder bevorzugt galvanisch Metall abgeschieden, das von dem Basismetall verschieden sein kann. Die Resistschablone wird dann in üblicher Weise, z. B. durch Lösungsmittel oder mechanisch, entfernt, und schließlich wird die relativ dünne Metallschicht an den Stellen, die vorher von der Schablone abgedeckt waren, abgeätzt.

Im Rahmen der hier beschriebenen Leiterplattenfertigung wird das erfindungsgemäße Verfahren zu einem geeigneten Zeitpunkt nach der Bildbelichtung und vor dem Galvanisieren angewendet. Im wesentlichen kommen dabei zwei Alternativen in Betracht: Das Salz der Sulfonsäure kann bereits der Entwicklerlösung zugesetzt werden oder diese kann in Form einer wäßrigen Reinigungslösung nach dem Entwickeln zur Einwirkung gebracht werden. Es ist auch möglich und in manchen Fällen günstig, das Reinigungsmittel sowohl als Entwicklerzusatz als auch in Form einer weiteren Behandlungslösung anzuwenden.

Die als Reinigungsmittel bei dem erfindungsgemäßen Verfahren verwendeten wasserlöslichen Sulfonsäuren oder Sulfonsäuresalze sind als solche bekannt. Geeignete Beispiele sind in den DE-A-1 910 860 und 1 917 300 beschrieben. Die Verbindungen können eine oder mehrere, bevorzugt eine Sulfonsäuregruppe im Molekül enthalten. Sie leiten sich von gesättigten oder ungesättigten aliphatischen Kohlenwasserstoffen ab, die bevorzugt nicht mehr als eine Doppelbindung im Molekül enthalten. Außer der Sulfonsäuregruppe können die Verbindungen andere Substituenten, wie Halogenatome, Alkoxy- und bevorzugt Hydroxygruppen, aufweisen. Die Kohlenwasserstoffkette kann verzweigt oder unverzweigt sein. Die unverzweigten Verbindungen sind besonders leicht zugänglich und biologisch abbaubar und werden daher bevorzugt. Die Kettenlänge beträgt im allgemeinen 8 bis 30, vorzugsweise 10 bis 22 C-Atome. Wenn es sich um Homologengemische unterschiedlicher Kettenlänge handelt, ist hiermit die mittlere Anzahl von C-Atomen gemeint. Wenn die Verbindungen als wasserlösliche Salze vorliegen, kommen insbesondere die Alkali-, Ammonium- und Erdalkalisalze in Betracht. Die Alkalisalze, besonders die Natrium- und Kaliumsalze, werden im allgemeinen wegen ihrer guten Wasserlöslichkeit bevorzugt.

Beispiele für geeignete Sulfonsäuren, die auch in Form ihrer Natrium-, Kalium, Calcium- oder Magnesiumsalze angewendet werden können, sind:

2-Hydroxy-hexadecan-sulfonsäure-(1),
Hexadecansulfonsäure,
2-Hydroxy-tetradecansulfonsäure-(1),
$C_{14} - C_{16}$-Olefinsulfonsäure,
2-Hydroxy-n-alkan($C_{12} - C_{14}$)sulfonsäure,
Alken-($C_{15} - C_{18}$)-disulfonsäure.

Die Konzentration des Reinigungsmittels in der wäßrigen Lösung liegt im allgemeinen im Bereich von 0,05 bis 15, vorzugsweise zwischen 0,1 und 10 Gew.-%. Wenn das Mittel, wie oben erwähnt, als Bestandteil der Entwicklerlösung angewendet wird, werden Konzentrationen von etwa 0,1 bis 5 Gew.-% bevorzugt. Wenn es in Form einer getrennten Behandlungslösung angewendet wird, werden zumeist höhere Konzentrationen, etwa im Bereich von 1 bis 8 Gew.-% bevorzugt.

Wenn die Sulfonsäure bzw. ihr Salz nicht in alkalischer Lösung angewendet wird, kann ihre Wirkung durch Zusatz einer Mineralsäure oder einer Carbonsäure gesteigert werden. Als Mineralsäuren sind solche geeignet, die die Resistschablone nicht angreifen, z. B. Schwefelsäure oder Phosphorsäure. Phosphorsäure wird besonders bevorzugt. Als Carbonsäuren werden nichtflüchtige Carbonsäuren, insbesondere solche mit mindestens zwei Carboxylgruppen, bevorzugt. Die Säure kann in Mengen von 0,5 bis 30, vorzugsweise von 2 bis 15 Gew.-%, zugesetzt werden.

Außerdem können der Reinigungslösung bzw. dem Entwickler kleine Mengen mit Wasser mischbarer organischer Lösungsmittel, z. B. aliphatische Alkohole mit 1 bis 5 C-Atomen oder Glykolhalbäther solcher Alkohole, zugesetzt werden. Hiervon werden normalerweise weniger als 20 Gew.-%, vorzugsweise nicht mehr als 5 Gew.-% zugesetzt.

Wenn die die Sulfonsäuren bzw. deren Salze enthaltende Lösung zum Schäumen neigt, können auch in bekannter Weise kleine Mengen handelsüblicher Entschäumer zugesetzt werden.

Die Einwirkung der Reinigungslösung erfolgt gewöhnlich bei Raumtemperatur, die Wirkung kann in manchen Fällen durch Temperaturerhöhung, etwa bis 60°C, gesteigert werden. Die Einwirkungszeit kann je nach Art der Resistschicht, Konzentration und Temperatur der Lösung sowie in Abhängigkeit von weiteren Reinigungsschritten, wie Anätzen, sehr unterschiedlich sein. Im allgemeinen liegt sie zwischen 20 Sekunden und 10 Minuten. In den meisten Fällen sind Zeiten von etwa 1 – 3 Minuten ausreichend.

Die Anwendung kann durch Tauchen, Sprühen oder auf andere geeignete Weise erfolgen.

Als Metalle, die dem erfindungsgemäßen Verfahren unterworfen werden, kommen vor allem Kupfer und Kupferlegierungen mit einem Kupfergehalt von mindestens 30% in Betracht.

Als Resistschichten werden, wie oben erwähnt, lichthärtbare, insbesondere photopolymerisierbare Schichten, die als wesentliche Bestandteile polymere Bindemittel, radikalisch polymerisierbare Verbindungen, insbesondere Acryl- oder Methacrylsäureester, mit mindestens zwei äthylenisch ungesättigten Gruppen im Molekül und Photoinitiatoren enthalten. Geeignete photopolymerisierbare Materialien sind in den DE-A-2 064 079, 2 363 806, 2 448 821 und 2 448 850 beschrieben. Das erfindungsgemäße Verfahren ist bei solchen Materialien besonders wirksam, die zur Verbesserung der Haftung auf Kupfer und damit zur Erhöhung der Beständigkeit der Schablone gegenüber aggressiven galvanischen Bädern Haftvermittler enthalten. Allgemein werden auch solche Materialien bevorzugt, die sich mit wäßrig-alkalischen Lösungen entwickeln lassen. Als Entwickler sind Lösungen von alkalischen Salzen, wie Silikaten, Phosphaten, Boraten oder Carbonaten der Alkalimetalle geeignet, die ggf. auch kleine Mengen organischer Lösungsmittel enthalten können.

Nach dem Entwickeln wird, falls das nicht bereits mit der Entwicklerlösung geschehen ist, die freigelegte Metalloberfläche mit einer wäßrigen Reinigerlösung nach dem erfindungsgemäßen Verfahren behandelt. Nach dieser Behandlung kann in bekannter Weise die Metalloberfläche z. B. mit einem Oxydationsmittel angeätzt werden. Dieser Ätzschritt kann bei Anwendung des erfindungsgemäßen Verfahrens in wesentlich kürzerer Zeit und damit schonender für die Metallfolie durchgeführt werden. Es schließt sich dann in bekannter Weise die gewünschte Galvanisierung an.

Durch die Erfindung wird erreicht, daß sogenannte Resistschleier und andere organische Verunreinigungen von der Metalloberfläche vollständig und schonend entfernt werden. Die an den gereinigten Metalloberflächen galvanisch abgeschiedenen Metallbahnen haften auch bei sehr geringer Breite fest auf dem Basismetall und werden weder bei der Entfernung der gehärteten Resistschablone (Strippen) noch bei anderweitiger mechanischer Beanspruchung davon getrennt.

Die folgenden Beispiele erläutern bevorzugte Ausführungsformen des erfindungsgemäßen Verfahrens. Mengenverhältnisse und Prozentzahlen sind, wenn nichts anderes angegeben ist, in Gewichtseinheiten zu verstehen. Die Mengen der Schichtbestandteile sind in Gewichtsteilen *(Gt)* angegeben.

## Beispiele 1–7

Eine Anzahl Trockenresistmaterialien mit photopolymerisierbarer Schicht wurde wie folgt hergestellt. Eine Lösung von

| | |
|---|---|
| 5,6 Gt | des Umsetzungsprodukts aus 1 Mol 2,2,4-Trimethyl-hexamethylen-diisocyanat und 2 Mol 2-Hydroxyäthylmethacrylat, |
| 6,5 Gt | eines Terpolymerisats aus Styrol, n-Hexyl-methacrylat und Methacrylsäure (10 : 60 : 30) mit einer Säurezahl von ca. 190, |
| 0,2 Gt | 9-Phenyl-acridin, |
| 0,015 Gt | 4,4'-Bis-dimethylamino-benzophenon, |
| 0,15 Gt | Triäthylenglykol-dimethacrylat und |
| 0,025 Gt | eines blauen Azofarbstoffs, erhalten durch Kuppeln von 2,4-Dinitro-6-chlorbenzoldiazoniumsalz mit 2-Methoxy-5-acetylamino-N-cyanoäthyl-N-hydroxyäthylanilin, in |
| 28 Gt | Butanon-2 |

wird auf eine 25 µm starke Polyäthylenterephthalatfolie aufgeschleudert. Anschließend wird die Schicht 2 Minuten bei 100°C im Trockenschrank getrocknet und dann mit einer 25 µm starken Deckfolie abgedeckt. Die trockene Schicht hat eine Dicke von 25 µm.

Die Kupferoberfläche von mit 35 µm starker Kupferfolie kaschierten Phenoplast-Schichtstoffplatten der Größe 100 × 150 mm wird mechanisch mit Bimsmehl oder mit einer Bürstmaschine gereinigt und nach intensivem Abspülen mit Wasser mit Luft trocken geblasen.

Auf die so vorbehandelten Cu-Platten wird der Trockenresist — nach Abziehen der Deckfolie — mit Hilfe eines handelsüblichen Laminators auflaminiert.

Die Proben werden anschließend durch die Trägerfolie unter einer Negativ-Vorlage mit einer Xenon-Lampe von 8 kW, Lampenabstand 80 cm, 17 Sekunden belichtet. Als Belichtungsmaske dient dabei eine Vorlage mit parallelliegenden Streifen von 30 mm Länge und je 100 µm Breite und Parallelabstand.

Nach Abziehen der Trägerfolien werden die nicht belichteten Schichtbereiche mit einer Entwicklerlösung ausgewaschen. Die so entwickelten Platten werden dann in ein Reinigerbad getaucht.

Die Entwicklerlösung besteht aus einer wäßrigen Natriumcarbonatlösung von 0,8 Gew.-%. Dieser Lösung werden in einigen Fällen Salze von aliphatischen Sulfonsäuren zur Verbesserung der Reinigungswirkung zugesetzt. Die entsprechenden Angaben sind der folgenden Tabelle 1 zu entnehmen. Dort sind ferner die Sprühzeiten für die Entwicklung und die Entwicklertemperatur angegeben. Es ist weiterhin die Zusammensetzung, Einwirkungszeit und -temperatur der Reinigerlösung sowie das Versuchsergebnis aufgeführt. Das Beispiel 1 ist ein Vergleichsbeispiel, bei dem als Reiniger eine wäßrige Polyäthylenoxid-alkyläther-Lösung verwendet wird.

Die entwickelte und gereinigte Platte erfährt noch folgende Behandlung:

| | |
|---|---|
| 1 Minute | intensive Wasserspülung, |
| 30 Sekunden | Tauchbad in 15%iger Ammoniumpersulfat-Lösung, |
| 45 Sekunden | Wasserspülung, |
| 1 Minute | Tauchbad in 10%iger Schwefelsäure, |
| 30 Minuten | Kupferbad bei 2,5 A/dm², bezogen auf die zu verkupfernde Fläche, bei 20 – 25° C. |

Das verwendete galvanische Kupferbad ist ein handelsübliches Bad (Kupfer-PC-Bad = »printed circuit«-Bad der Firma Schlötter, Geislingen/Steige, BRD).

Nach intensiver Wasserspülung und sorgfältigem Trockenblasen der Platten wird nach 2 Stunden das Haftverhalten der 100 µm breiten Kupferbahnen mit einem feinen Radiermesser geprüft. Pro Platte werden 10 nebeneinanderliegende, jeweils 100 µm breite Streifen mit dem Messer bearbeitet.

Tabelle 1

| Beispiel Nr. | Entwicklerzusatz | | Sprühzeit Sekunden | Temperatur °C | Reinigerlösung | | | | Haftungstest | | | |
|---|---|---|---|---|---|---|---|---|---|---|---|---|
| | Art | Menge Gew.-% | | | Bestandteile | Menge Gew.-% | Tauchzeit Sekunden | Temperatur °C | a | b | c | d |
| 1 | — | — | 60 | 23 | TNG | 4,5 | 130 | 23 | 7 | — | + | — |
| 2 | A | 0,1 | 55 | 25 | — | — | — | — | 0 | — | — | — |
| 3 | A | 0,2 | 50 | 40 | $H_3PO_4$ A | 10 5 | 120 | 23 | 0 | — | — | — |
| 4 | — | — | 70 | 25 | Citronensäure A | 10 5 | 120 | 23 | 0 | — | — | — |
| 5 | — | — | 70 | 25 | A | 5 | 120 | 23 | 0 | — | — | — |
| 6 | — | — | 70 | 25 | $H_3PO_4$ A | 10 5 | 120 | 23 | 0 | — | — | — |
| 7 | A | 0,5 | 45 | 25 | $H_3PO_4$ B | 10 2 | 120 | 23 | 0 | — | — | — |

TNG = Tridecyl-nonaglykoläther
A = Natrium-n-alkansulfonat ($C_{13}-C_{18}$)
B = n-Alkansulfonsäure ($C_{13}-C_{18}$)

a = Zahl der angehobenen Kupferbahnen
b = Die Kupferbahnen sind leicht und vollständig abzuheben; ja (+), nein (−)
c = Die Kupferbahnen sind schwierig, aber vollständig abzuheben; ja (+), nein (−)
d = Die Kupferbahnen sind schwierig und nur teilweise abzuheben; ja (+), nein (−)

## Beispiele 8—26

Wie in Beispiel 1 wurden Trockenresistfolien hergestellt und verarbeitet. Als Beschichtungslösung wurde die folgende Lösung verwendet:

5,6 Gt des Umsetzungsprodukts aus
1 Mol Hexamethylendiisocyanat und
2 Mol Hydroxypropylmethacrylat,

6,5 Gt eines Terpolymerisats aus Styrol, n-Hexylmethacrylat und Methacrylsäure (10 : 60 : 30) mit einer Säurezahl von 185,

0,2 Gt 9-Phenyl-acridin,

0,15 Gt Triäthylenglykol-dimethacrylat,

0,015 Gt 4,4'-Bis-dimethylamino-benzophenon,

0,025 Gt des in den Beispielen 1—7 angegebenen blauen Azofarbstoffs und

0,15 Gt 3-Mercapto-propionsäure-2,4-dichloranilid in

30 Gt Butanon.

Die photopolymerisierbaren Schichten wurden in gleicher Weise wie in den Beispielen 1—7 auf Kupfer-Schichtstoffplatten übertragen, belichtet, entwickelt und dann wie in den Beispielen 1—7 beschrieben, nachbehandelt. Die Art der Behandlung und die Ergebnisse sind in der folgenden Tabelle 2 zusammengestellt. Die Symbole haben, soweit sie nicht in Fußnoten erläutert sind, die gleiche Bedeutung wie in Tabelle 1. Die Beispiele 8 und 9 sind Vergleichsbeispiele.

Tabelle 2

| Beispiel Nr. | Entwicklerzusatz | | Sprühzeit Sekunden | Temperatur °C | Reinigerlösung | | | | Haftungstest | | | |
|---|---|---|---|---|---|---|---|---|---|---|---|---|
| | Art | Menge Gew.-% | | | Bestandteile | Menge Gew.-% | Tauchzeit Sekunden | Temperatur °C | a | b | c | d |
| 8 | − | − | 60 | 23 | $TNG$ $H_3PO_4$ | 4,0 8 | 130 | 23 | 10 | + | − | − |
| 9 | − | − | 60 | 23 | $H_3PO_4$ | 10 | 40 | 25 | 10 | + | − | − |
| 10 | A | 0,2 | 45 | 25 | − | − | − | − | 0 | − | − | − |
| 11 | A | 0,1 | 55 | 25 | − | − | − | − | 0 | − | − | − |
| 12 | A | 0,2 | 50 | 40 | $H_3PO_4$ A | 10 5 | 120 | 23 | 2 | − | − | + |
| 13 | − | − | 70 | 25 | B | 10 | 60 | 23 | 3 | − | − | + |
| 14 | − | − | 70 | 25 | B | 5 | 60 | 23 | 0 | − | − | − |
| 15 | − | − | 70 | 25 | $H_2SO_4$ A | 10 5 | 120 | 23 | 2 | − | − | + |
| 16 | − | − | 70 | 25 | $H_3PO_4$ A | 10 5 | 120 | 23 | 0 | − | − | − |
| 17 | − | − | 70 | 25 | $H_3PO_4$ A | 10 5 | 120 | 50 | 0 | − | − | − |
| 18 | − | − | 70 | 25 | $H_3PO_4$ B | 10 2 | 120 | 23 | 3 | − | − | + |
| 19 | A | 0,5 | 45 | 25 | $H_3PO_4$ B | 10 2 | 120 | 23 | 0 | − | − | − |
| 20 | − | − | 60 | 25 | $H_3PO_4$ A | 10 3 | 120 | 23 | 0 | − | − | − |
| 21 | − | − | 60 | 25 | $H_3PO_4$ A | 8 4 | 120 | 23 | 0 | − | − | − |

Tabelle 2

| Beispiel Nr. | Entwicklerzusatz | | Sprühzeit Sekunden | Temperatur °C | Reinigerlösung | | | | Haftungstest | | | |
|---|---|---|---|---|---|---|---|---|---|---|---|---|
| | Art | Menge Gew.-% | | | Bestandteile | Menge Gew.-% | Tauchzeit Sekunden | Temperatur °C | a | b | c | d |
| 22 | – | – | 60 | 25 | C | 5 | 120 | 23 | 0 | – | – | – |
| 23 | – | – | 60 | 25 | $H_3PO_4$ C | 10 5 | 120 | 23 | 0 | – | – | – |
| 24 | – | – | 60 | 25 | $H_3PO_4$ D | 10 5 | 120 | 23 | 0 | – | – | – |
| 25 | – | – | 60 | 25 | $H_3PO_4$ E | 10 5 | 120 | 23 | 0 | – | – | – |
| 26 | – | – | 60 | 25 | $H_3PO_4$ F | 10 5 | 120 | 23 | 0 | – | – | – |

TNG = Tridecyl-nonaglykoläther  
A   = Natrium-n-alkansulfonat $(C_{13} - C_{18})$  
B   = n-Alkansulfonsäure $(C_{12} - C_{18})$  
C   = Natriumalkensulfonat $(C_{15} - C_{18})$  
D   = Kaliumalkensulfonat $(C_{14} - C_{16})$  
E   = Calciumalkensulfonat $(C_{15} - C_{18})$  
F   = Magnesiumalkensulfonat $(C_{15} - C_{18})$

a = Zahl der angehobenen Kupferbahnen  
b = Die Kupferbahnen sind leicht und vollständig abzuheben; ja (+), nein (−)  
c = Die Kupferbahnen sind schwierig, aber vollständig abzuheben; ja (+), nein (−)  
d = Die Kupferbahnen sind schwierig und nur teilweise abzuheben; ja (+), nein (−)

# 0 013 310

Beispiele 27 — 35

Eine Lösung aus

| | |
|---|---|
| 6,5 Gt | eines Terpolymerisats aus n-Hexylmethacrylat, Methacrylsäure und Strol (60 : 30 : 10 Gew.-Teile) mit einem mittleren Molgewicht von ca. 35 000, |
| 2,8 Gt | des unten angegebenen gesättigten Polyurethans, |
| 2,8 Gt | eines polymerisierbaren Polyurethans, das durch Umsetzung von 2 Molen 2,2,4-Trime-thyl-hexamethylen-diisocyanat mit 1 Mol wasserfreiem Triäthylenglykol und weitere Umsetzung des Reaktionsprodukts mit 2 Molen Hydroxyäthylmethacrylat analog dem gesättigten Polyurethan hergestellt wurde, |
| 2,8 Gt | 4-Hydroxy-(2-äthyl-hexyl)benzoat, |
| 0,2 Gt | 9-Phenyl-acridin, |
| 0,1 Gt | 3-Mercapto-propionsäure-2,4-dichloranilid und |
| 0,025 Gt | des Farbstoffs »Disperse Red« (C. J. 179) in |
| 25 Gt | Methyläthylketon und |
| 2 Gt | Äthanol |

wird auf eine 25 μm dicke Polyäthylenterephthalatfolie durch Gießen aufgetragen. Die Schicht wird 3 Minuten bei 100° C im Trockenschrank getrocknet und hat dann eine Dicke von 45 μm.

### Synthese des Polyurethans

In einem Dreihalskolben mit Rührer, Rückflußkühler mit aufgesetztem $CaCl_2$-Trockenrohr und Tropftrichter werden 2 Mole 2,2,4-Trimethyl-hexamethylendiisocyanat in 800 g Methyläthylketon vorgelegt. Nach Zugabe einer als Katalysator wirkenden Mischung aus

| | |
|---|---|
| 1,5 g | Eisen(III)-acetylacetonat und |
| 2,0 g | Diäthylcyclohexylamin in |
| 50,0 g | Methyläthylketon |

wird 1 Mol wasserfreies Triäthylenglykol, gelöst in 50 g Methyläthylketon so zudosiert, daß die Reaktionstemperatur konstant auf 70±1°C gehalten wird. Hierzu wird von außen durch ein Wasserbad, das zunächst eine Temperatur von 60°C hat, erwärmt und — nach Erreichung der gewünschten Innentemperatur durch die Reaktionswärme der Polyadditionsreaktion — gekühlt (Badtemperatur: ca. 40 bis 50°C). Nach Ende der Zugabe des Triäthylenglykols werden 2 Mole Triäthylenglykolmonobutyläther bei 70°C zugetropft. Nach Ende der Reaktion wird noch 2 Std. bei 70°C gerührt, dann wird die Lösung abgekühlt. Das so erhaltene Polyurethan wird nach Abdestillieren des Lösungsmittels als Harz in dem photopolymerisierbaren Gemisch verwendet.

Die weitere Verarbeitung erfolgt, wie es in den Beispielen 1 bis 7 beschrieben ist. Die Einzelangaben sind in der Tabelle 3 zusammengestellt, wobei die Beispiele 27 und 35 Vergleichsbeispiele sind.

Tabelle 3

| Beispiel Nr. | Entwicklerzusatz | | Sprühzeit Sekunden | Temperatur °C | Reinigerlösung | | Tauchzeit Sekunden | Temperatur °C | Haftungstest | | | |
|---|---|---|---|---|---|---|---|---|---|---|---|---|
| | Art | Menge Gew.-% | | | Bestandteile | Menge Gew.-% | | | a | b | c | d |
| 27 | − | − | 120 | 23 | $H_3PO_4$<br>TNG | 8<br>4 | 130 | 23 | 10 | + | − | − |
| 28 | A | 0,2 | 90 | 25 | − | − | − | − | 0 | − | − | − |
| 29 | − | − | 140 | 25 | $H_2SO_4$<br>A | 10<br>5 | 120 | 23 | 1 | − | − | + |
| 30 | − | − | 140 | 25 | $H_3PO_4$<br>A | 10<br>5 | 120 | 23 | 0 | − | − | − |
| 31 | − | − | 140 | 25 | $H_3PO_4$<br>B | 10<br>2 | 120 | 23 | 3 | − | − | + |
| 32 | A | 0,5 | 90 | 25 | $H_3PO_4$<br>B | 10<br>2 | 120 | 23 | 0 | − | − | − |
| 33 | − | − | 120 | 25 | C | 5 | 120 | 23 | 0 | − | − | − |
| 34 | − | − | 120 | 25 | $H_3PO_4$<br>D | 10<br>5 | 120 | 23 | 0 | − | − | − |
| 35 | − | − | 120 | 25 | − | − | − | − | 10 | + | − | − |

0 013 310

## Patentansprüche

1. Verfahren zur Herstellung eines Photoresistbilds, bei dem auf einen Schichtträger aus Kupfer oder einer Kupferlegierung eine photopolymerisierbare Photoresistschicht aufgebracht, bildmäßig belichtet und an den unbelichteten Bereichen mittels einer wäßrig-alkalischen Entwicklerlösung ausgewaschen wird, dadurch gekennzeichnet, daß man die Oberfläche des Trägers während des Entwickelns oder nach dem Entwickeln mit einer Lösung behandelt, die eine wasserlösliche aliphatische Sulfonsäure mit 8 bis 30 Kohlenstoffatomen oder ein wasserlösliches Salz einer solchen Sulfonsäure enthält.

2. Verfahren nach Anspruch 1, dadurch gekennzeichnet, daß man die Oberfläche mit einer Lösung behandelt, die 0,05 bis 15 Gew.-% der Sulfonsäure oder des Sulfonsäuresalzes enthält.

3. Verfahren nach Anspruch 1, dadurch gekennzeichnet, däß man die Oberfläche mit der Lösung einer gesättigten oder einfach ungesättigten Sulfonsäure bzw. eines ihrer Salze behandelt.

4. Verfahren nach Anspruch 1, dadurch gekennzeichnet, daß man die Sulfonsäure bzw. das Sulfonsäuresalz der Entwicklerlösung zum Entwicklen einer bildmäßig belichteten Photoresistschicht zusetzt.

5. Verfahren nach Anspruch 1, dadurch gekennzeichnet, daß man die Oberfläche mit einer Lösung behandelt, die zusätzlich eine Mineralsäure oder eine wasserlösliche Carbonsäure enthält.

6. Verfahren nach Anspruch 5, dadurch gekennzeichnet, daß man die Oberfläche mit einer Lösung behandelt, die als Mineralsäure Phosphorsäure enthält.

7. Verfahren nach Anspruch 1, dadurch gekennzeichnet, daß man die Oberfläche mit einer Lösung behandelt, die zusätzlich ein mit Wasser mischbares organisches Lösungsmittel enthält.

## Claims

1. A process for the production of a photoresist image, in which a photopolymerizable photoresist layer is applied to a support of copper or a copper alloy, is exposed imagewise and is washed out of the unexposed areas by means of an aqueous-alkaline developer solution, which comprises treating the surface of the support, during or after the development, with a solution which contains a water-soluble aliphatic sulfonic acid, or a water-soluble salt of such a sulfonic acid, having 8 to 30 carbon atoms.

2. A process as climed in claim 1, which comprises treating the surface with a solution which contains 0.05 to 15% by weight of the sulfonic acid or of the sulfonic acid salt.

3. A process as claimed in claim 1, which comprises treating the surface with the solution of a saturated or mono-unsaturated sulfonic acid or of a salt thereof.

4. A process as climed in claim 1, which comprises adding the sulfonic acid or the sulfonic acid salt to the developer solution for developing a photoresist layer which has been exposed image-wise.

5. A process as claimed in claim 1, which comprises treating the surface with a solution which additionally contains a mineral acid or a water-soluble carboxylic acid.

6. A process as claimed in claim 5, which comprises treating the surface with a solution which contains phosphoric acid as the mineral acid.

7. A process as claimed in claim 1, which comprises treating the surface with a solution which additionally contains a water-miscible organic solvent.

## Revendications

1. Procédé pour la fabrication d'une image photorésist, dans lequel une couche photorésist photopolymérisable est appliquée sur un support de couche en cuivre ou en un alliage de cuivre, exposée à la lumière selon une image, et lavée aux endroits non exposés à la lumière au moyen d'une solution de développement aqueuse alcaline, caractérisé en ce qu'on traite la surface du support pendant le développement ou après le développement par une solution contenant un acide sulfonique aliphatique hydrosoluble ayant de 8 à 30 atomes de carbone ou un sel hydrosoluble d'un tel acide sulfonique.

2. Procédé selon la revendication 1 caractérisé en ce qu'on traite la surface par une solution contenant entre 0,05 et 15% en poids de l'acide sulfonique ou du sel de l'acide sulfonique.

3. Procédé selon la revendication 1, caractérisé en ce qu'on traite la surface par une solution d'un acide sulfonique saturé ou ayant une liaison insaturée, ou d'un sel d'un tel acide.

4. Procédé selon la revendication 1, caractérisé en ce qu'on ajoute l'acide sulfonique ou le sel de l'acide sulfonique à la solution pour le développement d'une couche photorésist exposée à la lumière selon une image.

5. Procédé selon la revendication 1, caractérisé en ce qu'on traite la surface par une solution contenant en outre un acide minéral ou un acide carboxylique hydrosoluble.

6. Procédé selon la revendication 5, caractérisé en ce qu'on traite la surface par une solution contenant en tant qu'acide minéral, l'acide phosphorique.

7. Procédé selon la revendication 1, caractérisé en ce qu'on traite la surface par une solution contenant additionnellement un solvant organique miscible à l'eau.

13